# FASCICULE DE BREVET EUROPEEN

(11) **EP 0 359 328 B1**
(45) Date de publication et mention de la délivrance du brevet: **15.12.1993**
(21) Numéro de dépôt: 89202282.3
(22) Date de dépôt: 11.09.1989
(51) Int. Cl.: H01L 23/60, G06K 19/06

(54) **Dispositif comportant un circuit électronique monté sur un support souple, protégé contre les décharges d'électricité statique, et carte souple le comprenant**
Anordnung mit einer elektronischen Schaltung, montiert auf einem biegsamen Träger, geschützt gegen elektrostatische Entladungen, und biegsame Karte mit dieser Anordnung
Device having an electronic circuit mounted on a flexible carrier, protected against electrostatic discharges, and flexible card comprising this device

(30) Priorité: 16.09.1988 FR 8812103
(43) Date de publication de la demande: 21.03.1990
(73) Titulaire: TRT TELECOMMUNICATIONS RADIOELECTRIQUES ET TELEPHONIQUES, 75013 Paris (FR); Philips Electronics N.V., 5621 BA Eindhoven (NL)
(72) Inventeur: Amiot, Lucien, F-75007 Paris (FR)
(74) Mandataire: Pyronnet, Jacques

(56) Documents cités:
- EP-A- 0 037 760
- EP-A- 0 064 558
- EP-A- 0 080 233
- FR-A- 2 370 403
- FR-A- 2 580 416
- US-A- 4 301 040

## Description

La présente invention a pour objet un dispositif comportant un circuit électronique monté solidairement sur un support souple comportant au moins une piste conductrice à laquelle une face supérieure dudit circuit est reliée par au moins un fil conducteur, ledit montage solidaire étant obtenu d'une part par solidarisation, au moyen d'une colle conductrice, d'une face inférieure du circuit électronique et du support souple et d'autre part par adjonction autour du circuit d'une résine, qui n'enrobe aucun fil conducteur, ledit dispositif étant revêtu extérieurement d'un vernis de protection.

Le dispositif proprement dit est constituée par un composant de circuit intégré dit encore microcircuit collé sur un circuit imprimé. Ce dispositif est couramment utilisé comme module actif dans une carte souple en matière plastique, l'ensemble constituant une carte électronique, encore appelée carte à mémoire et/ou à microprocesseur.

Deux problèmes techniques majeurs se posent pour la fabrication de la carte électronique.

Le premier problème est celui de la tenue mécanique du dispositif sur la carte support, suite aux flexions et torsions auxquelles est inévitablement soumise la carte électronique lors de son utilisation.

Il est connu de résoudre ce premier problème technique en prenant des dispositions particulières pour la conception du dispositif, de la carte support et pour la solidarisation de ceux deux éléments concernant le dispositif. Il s'agit de disposer ladite résine sur au moins deux bords latéraux opposés du circuit de façon qu'elle déborde sur les deux autres bords latéraux et de manière telle qu'aucun fil conducteur ne soit enrobé. La carte support comporte quant à elle un logement muni localement en son fond d'une charge de résine qui constitue une entretoise entre le fond du logement et la partie supérieure du microcircuit lors de la solidarisation du dispositif à la carte par collage des bords du circuit imprimé du dispositif aux bords du logement de la carte. Il demeure ainsi, après solidarisation un espace libre, à l'intérieur dudit logement, dans lequel les conducteurs peuvent suivre sans effort nuisibles à leurs contacts d'extrémités les déformations répétées de la carte électronique.

Le deuxième problème technique que se propose de résoudre la présente invention est la formation de charges électrostatiques sur la carte électronique, pouvant conduire à perturber le fonctionnement ou même à détruire le microcircuit, surtout si ce dernier est réalisé en technologie MOS. Cette accumulation de charges électrostatiques est due à l'utilisation de la carte en matière plastique dans des environnements divers provoquant des frottements générateurs de tribo-électricité tels que le transit dans la poche de l'utilisateur, le passage dans divers appareils électroniques de banque ou autres destinés à coopérer avec la carte. De la demande de brevet français 2 480 008 on connaît une carte électronique dont le circuit électronique ainsi que les conducteurs, qui y sont reliés et qui se terminent par des bornes de contact sont enrobés dans un matériau plastique. Pour éviter les décharges électrostatiques entre bornes de contact, un volume conducteur équipotentiel constituant une cage de Faraday entoure au moins partiellement le circuit électronique. Ce montage présente l'inconvénient de n'être pas mécaniquement sûr, étant donnée sa rigidité, notamment le fait que les conducteurs issus du circuit ne sont pas libres. Ce montage présente aussi un défaut électrique du fait que, lorsque le circuit est mis sous tension il peut exister des courants de fuite ou des court-circuits nuisibles entre conducteurs ou bornes de contacts voisins. Une autre solution connue pour remédier à l'inconvénient des décharges électrostatiques consiste à faire subir à la carte support en matière plastique un traitement antistatique de surface. Cette opération est en général réalisée par dépôt d'un liquide antistatique sur la surface externe du support. On constate que la tenue dans le temps de ce traitement est aléatoire compte tenu des utilisations variées des cartes à mémoire qui provoquent l'arrachement progressif de cette couche antistatique externe. Encore une autre solution consisterait à traiter dans la masse avec un produit antistatique les feuilles de matière plastique constituant la carte support. Dans ce dernier cas, cependant, les procédés actuels d'obtention des cartes supports par laminages à chaud sont incompatibles avec le traitement précité.

L'idée première de l'invention consiste à faire subir un traitement antistatique à l'environnement immédiat du microcircuit en mettant à profit la structure particulière connue indiquée ci-dessus visant à résoudre le problème de tenue mécanique du microcircuit sur son support, et qui laisse les conducteurs libres à l'intérieur d'un logement de la carte.

Les inconvénients de l'art antérieur sont atténués ou supprimés grâce au fait que le dispositif décrit au premier paragraphe est remarquable en ce que ladite colle conductrice, ladite résine et ledit vernis de protection contiennent quelques % en poids ou en volume d'un agent antistatique liquide.

Le microcircuit ainsi protégé contre la formation d'électricité statique sur tout ou partie de ses faces peut ensuite être solidarisé comme décrit ci-dessus à la carte support.

Un mode de réalisation préféré de la carte électronique selon l'invention consiste en ce que cette dernière comporte, sur les parois de son logement, une couche de produit antistatique, ainsi qu'un dispositif traité avec un agent antistatique comme indiqué ci-dessus, collé dans ledit logement.

La description qui suit en regard des dessins annexés, le tout donné à titre d'exemple, fera bien comprendre comment l'invention peut être réalisée.

Les figures 1a et 1b représentent une vue de dessus et en coupe verticale suivant A-A′ respectivement un mode de réalisation du dispositif selon l'invention.

La figure 2 montre, en coupe verticale, un dispositif selon l'invention après insertion dans un logement d'une carte support, l'ensemble constituant une carte électronique.

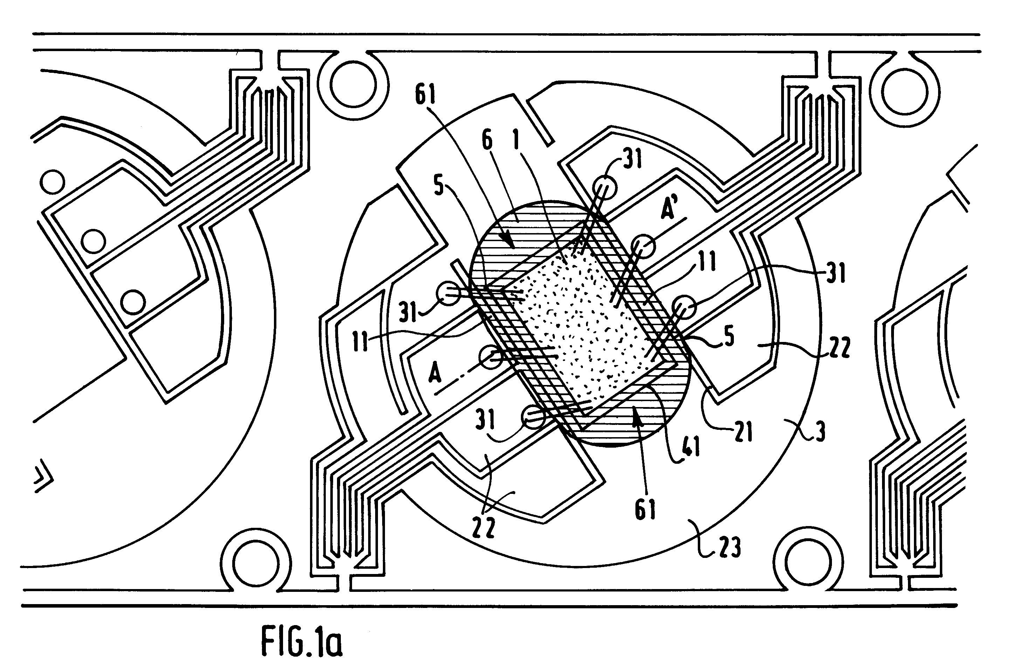

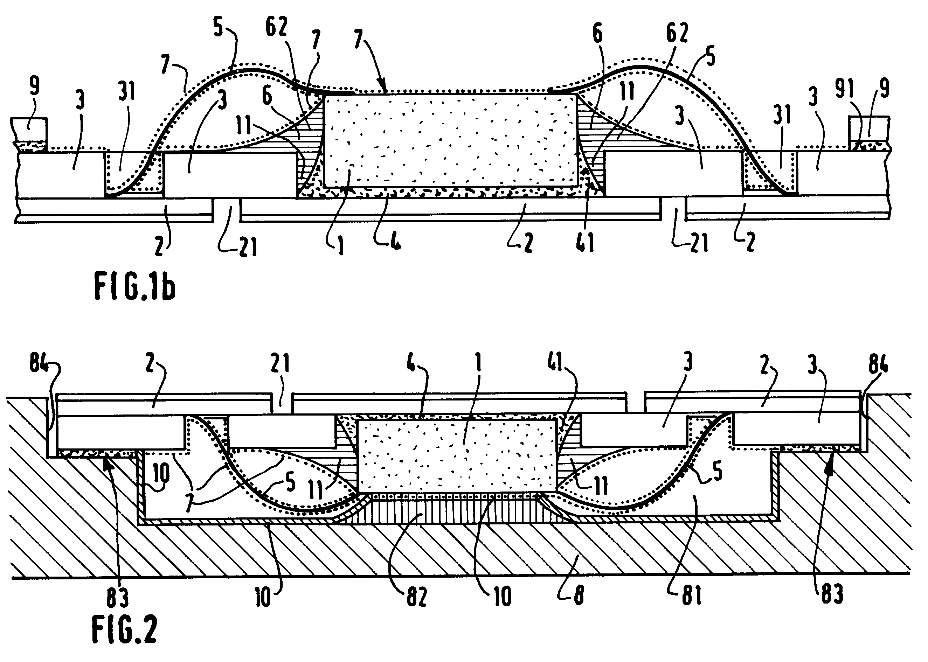

Selon les figures 1a et 1b, un circuit électronique par exemple une pastille semi-conductrice 1 est collé de manière conductrice sur une couche conductrice 2, en l'espèce une feuille de cuivre Cu sur laquelle sont déposées électrolytiquement une couche de Ni, puis une couche d'Au, disposée à la face inférieure d'une couche isolante, en l'espèce un film polyester 3. La couche isolante 3 et la couche conductrice 2 forment un support souple. La couche de colle conductrice 4 peut être une résine époxy contenant au moins de l'Ag. Cette couche de colle 4 adhère à la surface inférieure du substrat de la pastille 1. La couche conductrice 2 présente des ouvertures 21 la séparant électriquement en différentes zones 22 permettant d'isoler les prises de contact électrique. Des puits 31 traversent la couche isolante 3 de manière à permettre la mise en place par soudure ultra-sons de fils de connexion 5 entre la face supérieure de la pastille 1 et les zones correspondantes 22. On notera que la zone métallique à laquelle est collée la pastille 1 s'étend autour des zones 22 de façon à constituer un anneau de garde 23 qui protége, extérieurement, de façon connue, les zones conductrices 22 contre les décharges électrostatiques.

On trouvera une description plus détaillée d'un exemple de mise en oeuvre dans la demande de brevet français FR 2 580 416 déposée le 12 avril 1985 et intitulée "procédé et dispositif pour fabriquer une carte d'identification électronique".

Une résine polymérisable 6, par exemple une résine époxy est disposée en 61 le long de deux bords opposés de la pastille semiconductrice 1. La résine est dosée de manière que, après un palier de température suffisant pour ramollir la résine sans la polymériser, celle-ci flue le long de canaux 11 entre deux autres côtés opposés de la pastille 1 et les bords adjacents de la couche isolante 3 de manière à former deux zones 62 de résine rejoignant les régions de bord 41 de la colle conductrice. Du fait de ce fluage, la forme des zones 11 revêt latéralement un profil progressif qui d'une part augmente la surface d'adhérence et d'autre part évite toute rupture de section qui serait favorable à des ruptures mécaniques lors de l'utilisation. En outre, dans l'exemple représenté, les zones 11 sont situées en dessous des fils conducteurs 5 qui restent donc non enrobés par la résine 6. En outre, les zones 61 et 62 de résine ne débordent pas en hauteur au dessus de la face supérieure de la pastille 1, ce qui n'introduit aucun inconvénient lors du montage ultérieur dans le logement d'une carte. On notera que le fluage de la zone 61 peut produire, sur les deux autres côtés latéraux opposés de la pastille 1 quatre zones qui ne se rejoignent pas. Du point de vue mécanique, la qualité de l'adhérence est pratiquement la même que dans le mode de réalisation de la figure 1, car le point le plus important est que la résine polymérisable entoure les coins de la pastille semiconductrice 1.

La mise en oeuvre d'une colle conductrice 4 pour la face inférieure de la pastille 1 et d'une résine polymérisable pour les côtés de celle-ci permet en outre d'améliorer le contact électrique de la face inférieure de la pastille avec la couche 2. En effet, il est possible d'utiliser des résines très fortement chargées en particules métalliques, en l'espèce Ag, et qui présentent intrinsèquement de moins bonnes performances mécaniques, étant donné que la fonction d'adhérence est en grande partie remplie par la résine polymérisable.

La phase finale de la fabrication du dispositif de la figure 1 consiste à revêtir ce dernier d'une couche de vernis protecteur 7 sur toute sa face supérieure, y compris les fils conducteurs 5.

Selon l'invention, pour protéger la pastille 1 qui constitue le circuit électronique contre les décharges d'électricité statique qui peuvent résulter de différences de potentiel élevées entre la pastille 1 et son environnement immédiat, il est prévu d'incorporer dans de faibles proportions un agent antistatique aux matériaux qui entourent la pastille sur ses différentes faces, à savoir la colle conductrice 4 à la face inférieure et une partie des bords latéraux, la résine polymérisable 6 aux bords latéraux et le vernis 7, à la partie supérieure et éventuellement à une partie des bords latéraux ainsi qu'autour des fils conducteurs 5. On utilise de préférence un agent antistatique liquide, dans une proportion de 5 à 7 % en volume, cet agent pouvant être différent selon les types de matériaux précités auxquels il est chaque fois incorporé de façon à ne pas altérer les autres propriétés mécaniques et électriques souhaitées pour ces matériaux. Les agents antistatiques qui conviennent pour les matériaux en question sont décrits dans la littérature technique. Il s'agit par exemple de colle argent pour la colle conductrice 4, de H 90 ou 353 pour la résine polymérisable 6, et de KATAFORT 680 connu sous la marque PROGYVEN, à raison de 7 % en volume, pour le vernis protecteur 7.

Selon la figure 2, le dispositif, en l'espèce celui des figures 1a et 1b est, après découpe, retourné et collé en 82 par la face supérieure de la pastille 1, ainsi qu'en 83 par la face supérieure de la couche isolante 3 dans un embrèvement périphérique 84 du logement 81. Le collage en 82 peut être réalisé par une couche de résine polyuréthane, alors qu'en 83 celui-ci peut être réalisé par un adhésif double face pelable 9 selon la technique décrite dans la demande de brevet français FR 2 580 416 précitée. Dans ce cas, la couche pelable 91 de l'adhésif 9 sert de masque au vernis de protection 7.

La carte support 8 peut être réalisée en chlorure de polyvinyle (PVC), polycarbonate, ou autre matière plastique souple. La carte support peut ne pas être traitée avec un matériau antistatique, le montage du dispositif dans le logement de la carte s'effectuant comme décrit ci dessus.

Selon un mode de réalisation préféré, une couche de revêtement antistatique est vaporisée contre les parois du logement 81, préalablement au collage du dispositif dans le logement.

La couche de résine polyuréthane en 82 peut aussi contenir un produit antistatique qui lui est adapté.

Selon cet autre mode de réalisation, on obtient ainsi un deuxième écran protecteur, pour le circuit électronique, contre les charges électrostatiques qui peuvent être engendrées sur la carte support en matière plastique.

L'invention ne se limite pas aux modes de réalisation représentés et s'applique à tous les cas où une pastille doit être fixée sur un support souple tel que celui convenant au montage sur une carte électronique souple.

L'invention permet d'obtenir, pour le dispositif, une tenue aux décharges électrostatiques qui peut varier de 6 kV à 15 kV selon la sensibilité du circuit.

## Revendications

1. Dispositif comportant un circuit électronique integré (1) monté solidairement sur un support souple comportant au moins une piste conductrice à laquelle une face supérieure dudit circuit est reliée par au moins un fil conducteur (5), ledit montage solidaire comportant d'une part une colle conductrice (4) contenant quelques % en poids ou en volume d'un agent antistatique, qui solidarise une face inférieure du circuit électronique et le support souple et d'autre part, autour du circuit, une résine polymérisable (6) contenant quelques % en poids ou en volume d'un agent antistatique, qui n'enrobe aucun fil conducteur (5), ledit dispositif étant revêtu extérieurement d'un vernis de protection (7) contenant quelques % en poids ou en volume d'un agent antistatique.

2. Dispositif selon la revendication 1, caractérisé en ce que ledit agent antistatique est liquide et additionné dans ladite colle conductrice, ladite résine et ledit vernis de protection dans une proportion comprise entre 5 % et 7 % en volume.

3. Dispositif selon la revendication 1, caractérisé en ce que ladite colle conductrice (4) est de la colle argent, que ladite résine polymérisable (6) est additionnée d'agent antistatique H 90 ou 353, et que ledit vernis de protection (7) est additionné d'agent antistatique Katafort 80 à raison de 7 % en volume.

4. Carte souple comportant un logement (81), caractérisée en ce qu'une couche de produit antistatique revêt les parois dudit logement (81) et qu'un dispositif selon l'une des revendications précédentes est collé dans ledit logement.

## Claims

1. An arrangement comprising an integrated electronic circuit (1) which is so mounted on a flexible support that it is integral therewith, said support having at least one conductive track to which an upper face of said circuit is connected via at least one conductive wire (5), said integral assembly comprising a conductive glue (4) which contains a few per cent by weight or by volume of an antistatic agent and which bonds together a lower surface of the electronic circuit and the flexible support, and comprising around the circuit, a polymerizable resin (6) which contains a few per cent by weight or by volume of an antistatic agent and which does not envelop any conductive wire (5), the exterior of said arrangement being covered by a protective varnish (7), which contains a few per cent by weight or by volume of an antistatic agent.

2. An arrangement as claimed in Claim 1, characterized in that said antistatic agent is liquid and is added to said conductive glue, said resin and said protective varnish in a proportion of between 5% and 7% by volume.

3. An arrangement as claimed in Claim 1, characterized in that said conductive glue (4) is silver glue, that an antistatic agent H90 or 353 is added to said polymerizable resin (6), and that an antistatic agent KATAFORT 80 is added to said protective varnish (7) in a quantity of 7 vol.%

4. A flexible card including a bedding (81), characterized in that a layer of an antistatic material lines the walls of said bedding (81) and that an arrangement as claimed in any one of the preceding Claims is cemented in said bedding.

## Patentansprüche

1. Anordnung mit einer integrierten elektronischen Schaltung (1), die derart auf einem biegsamen Träger angeordnet ist, daß sie einen integrierten Teil mit demselben bildet, wobei dieser Träger mindestens eine leitende Spur aufweist, mit der eine obere Fläche der genannten Schaltung über mindestens einen leitenden Draht (5) verbunden ist, wobei dieses integrierte Gebilde einerseits einen leitenden Kleber (4) mit einigen Gewichts- oder Volumenprozent eines antistatischen Mittels aufweist, die eine untere Fläche der elektronischen Schaltung und den biegsamen Träger isoliert, und andererseits um die Schaltung herum ein polymerisierbares Harz (6) mit einigen Gewichts- oder Volumen % eines antistatischen Mittels, das keinen einzigen leitenden Draht (5) umgibt, wobei die Anordnung auf der Außenseite mit einem Schutzlack (7) versehen ist, der einige Gewichts- oder Volumen % eines antistatischen Mittels enthält.

2. Anordnung nach Anspruch 1, dadurch gekennzeichnet, daß das genannte antistatische Mittel flüssig und dem leitenden Klebstoff zugefügt ist, das genannte Harz und der genannte Schutzlack in einem Verhältnis von 5 und 7 Volumen %.

3. Anordnung nach Anspruch 1, dadurch gekennzeichnet, daß der genannte leitende Klebstoff (4) Silberleim ist, daß ein antistatisches Mittel H90 oder 353 dem genannten polymerisierbaren Harz (6) zugefügt ist und daß ein antistatisches Mittel KATAFORT 80 dem genannten Schutzlack (7) in einer Menge von 7 Volumen % zugefügt worden ist.

4. Biegsame Karte mit einer Bettung (81), dadurch gekennzeichnet, daß eine Schicht aus einem antistatischen Material die Wände der genannten Bettung (81) bedeckt und daß eine Anordnung nach einem der vorstehenden Ansprüche in der genannten Bettung festgeklebt ist.
